# DEMANDE DE BREVET EUROPEEN

(11) **EP 3 016 141 A1**
(43) Date de publication de la demande: **04.05.2016**
(21) Numéro de dépôt: 15190269.9
(22) Date de dépôt: 16.10.2015
(51) Int. Cl.: H01L 27/146, H01L 27/12

(54) **CAPTEUR D'IMAGE À ÉLECTRODES VERTICALES**

(30) Priorité: 27.10.2014 FR 1460301
(71) Demandeur: COMMISSARIAT A L'ENERGIE ATOMIQUE ET AUX ENERGIES ALTERNATIVES, 75015 Paris (FR); STMicroelectronics (Crolles 2) SAS, 38920 Crolles (FR); STMicroelectronics (Grenoble 2) SAS, 38000 Grenoble (FR)
(72) Inventeur: CAZAUX, Yvon, 38100 GRENOBLE (FR); ROY, François, 38180 SEYSSINS (FR); GUILLON, Marie, 38120 FONTANIL-CORNILLON (FR); LAFLAQUIERE, Arnaud, 38000 GRENOBLE (FR)
(74) Mandataire: Thibon, Laurent

(57) **Abrégé**

L'invention concerne un capteur d'image disposé dans et sur un substrat semiconducteur (201) ayant une face avant et une face arrière, ce capteur comportant une pluralité de pixels (300) comprenant chacun : une zone photosensible (105), une zone de lecture (111), et une zone de stockage (107) s'étendant entre la zone photosensible (105) et la zone de lecture (111) ; une électrode verticale isolée (103) comportant une ouverture de transfert entre la zone photosensible (105) et la zone de stockage (107) ; et au moins un élément d'isolement parmi les suivants : a) une couche (201c) d'un matériau isolant s'étendant sous la surface de la zone photosensible (105) et de la zone de stockage (107) et ayant sa face avant en contact avec la face arrière de l'électrode (103) ; et b) un mur d'isolement (330) s'étendant verticalement dans l'ouverture, ou sous l'ouverture.

## Description

### Domaine

La présente demande concerne un capteur d'image comportant une pluralité de pixels formés dans et sur un substrat semiconducteur. On s'intéresse ici plus particulièrement à un capteur adapté à un mode de commande dit à obturation globale ("global shutter" en anglais), c'est-à-dire dans lequel tous les pixels du capteur sont exposés simultanément. Plus particulièrement, on s'intéresse ici à un capteur à électrodes de commande verticales.

### Exposé de l'art antérieur

Des structures de pixels à électrodes verticales, compatibles avec une commande à obturation globale, ont déjà été proposées par les demanderesses, notamment dans les demandes de brevet US2014183685 et EP2752878, dont le contenu est considéré comme faisant partie intégrante de la présente description. Il existe toutefois un besoin pour une amélioration des structures de ce type, visant notamment à diminuer leur sensibilité à certaines sources de bruit parasite.

### Résumé

Ainsi, un mode de réalisation prévoit un capteur d'image disposé dans et sur un substrat semiconducteur ayant une face avant et une face arrière, ce capteur comportant une pluralité de pixels comprenant chacun : une zone photosensible, une zone de lecture, et une zone de stockage s'étendant entre la zone photosensible et la zone de lecture ; une première électrode verticale isolée s'étendant depuis la face avant du substrat entre la zone photosensible et la zone de stockage, comprenant au moins une ouverture s'étendant depuis la face avant du substrat et définissant une zone de transfert de charges entre la zone photosensible et la zone de stockage ; et au moins un élément d'isolement parmi les suivants : a) une couche en un matériau isolant s'étendant au moins sous toute la surface de la zone photosensible et sous toute la surface de la zone de stockage et ayant sa face avant en contact avec la face arrière de ladite électrode ; et b) un mur d'isolement s'étendant verticalement dans ou en regard d'une partie inférieure de ladite ouverture, ou sous ladite ouverture, de façon que la profondeur de la zone de transfert de charges soit inférieure à la profondeur de ladite électrode.

Selon un mode de réalisation, chaque pixel comprend au moins l'élément d'isolement a).

Selon un mode de réalisation, le substrat est un substrat de type SOI comportant un support semiconducteur revêtu d'une couche isolante revêtue d'une couche semiconductrice, et, dans chaque pixel, l'élément d'isolement a) est la couche isolante du substrat.

Selon un mode de réalisation, dans chaque pixel, la zone photosensible, la zone de stockage, la zone de lecture, et la première électrode sont disposées dans la couche semiconductrice du substrat.

Selon un mode de réalisation, chaque pixel comprend au moins l'élément d'isolement b).

Selon un mode de réalisation, dans chaque pixel, le mur d'isolement vertical comprend une région dopée de même type de conductivité que le substrat et de niveau de dopage supérieur à celui du substrat, située dans une partie inférieure de l'ouverture formée dans la première électrode.

Selon un mode de réalisation, dans chaque pixel l'ouverture formée dans la première électrode s'étend sur une profondeur inférieure à la profondeur totale de la première électrode, et le mur d'isolement est constitué par la portion de la première électrode située sous ladite ouverture.

Selon un mode de réalisation, dans chaque pixel, le mur d'isolement est constitué par une tranchée isolante verticale s'étendant depuis la face arrière du substrat, en regard d'une partie inférieure de l'ouverture formée dans la première électrode.

Selon un mode de réalisation, dans chaque pixel : la zone photosensible comprend un premier caisson de type de conductivité opposé à celui du substrat, et la zone de stockage comprend un deuxième caisson de type de conductivité opposé à celui du substrat et de profondeur supérieure à celle du premier caisson ; la première électrode s'étend jusqu'à une profondeur supérieure ou égale à celle du deuxième caisson ; et le mur d'isolement vertical s'étend entre le plan de face arrière de la première électrode, et un plan situé sous le plan de face arrière du premier caisson.

Selon un mode de réalisation, chaque pixel comprend l'élément d'isolement a) et l'élément d'isolement b).

Selon un mode de réalisation, chaque pixel comporte en outre une deuxième électrode verticale isolée s'étendant depuis la face avant du substrat entre la zone de stockage et la zone de lecture, comprenant au moins une ouverture s'étendant depuis la face avant du substrat et définissant une zone de transfert de charges entre la zone de stockage et la zone de lecture.

Selon un mode de réalisation, dans chaque pixel, la zone photosensible est partiellement délimitée par au moins une troisième électrode verticale isolée s'étendant depuis la face avant du substrat.

Selon un mode de réalisation, dans chaque pixel, la zone de lecture est couplée à un circuit de lecture du pixel.

### Brève description des dessins

Ces caractéristiques et leurs avantages, ainsi que d'autres, seront exposés en détail dans la description suivante de modes de réalisation particuliers faite à titre non limitatif en relation avec les figures jointes parmi lesquelles :
les figures 1A à 1G sont des vues en coupe et de dessus représentant de façon schématique la structure d'un exemple d'un pixel d'un capteur d'image ;
la figure 2 est une vue en coupe représentant de façon schématique la structure d'un exemple d'un pixel d'un capteur d'image selon un premier mode de réalisation ;
les figures 3A et 3B sont des vues en coupe représentant de façon schématique la structure d'un exemple d'un pixel d'un capteur d'image selon un deuxième mode de réalisation ;
la figure 4 est une vue en coupe représentant de façon schématique une variante de réalisation du pixel des figures 3A et 3B ;
la figure 5 est une vue en coupe représentant de façon schématique une autre variante de réalisation du pixel des figures 3A et 3B ; et
la figure 6 est une vue en coupe représentant de façon schématique une autre variante de réalisation du pixel des figures 3A et 3B.

### Description détaillée

Par souci de clarté, de mêmes éléments ont été désignés par de mêmes références aux différentes figures et, de plus, comme cela est habituel dans la représentation des circuits intégrés, les diverses figures ne sont pas tracées à l'échelle. Par ailleurs, dans la présente demande, sauf indication contraire, les termes "approximativement", "sensiblement", "environ", "de l'ordre de", etc., signifient "à 20% près", et des références directionnelles telles que "supérieur", "inférieur", "surmontant", "au-dessus", "latéral", "horizontal", "vertical", etc., s'appliquent à des dispositifs orientés de la façon illustrée dans les vues en coupe correspondantes, étant entendu que, dans la pratique, ces dispositifs peuvent être orientés différemment.

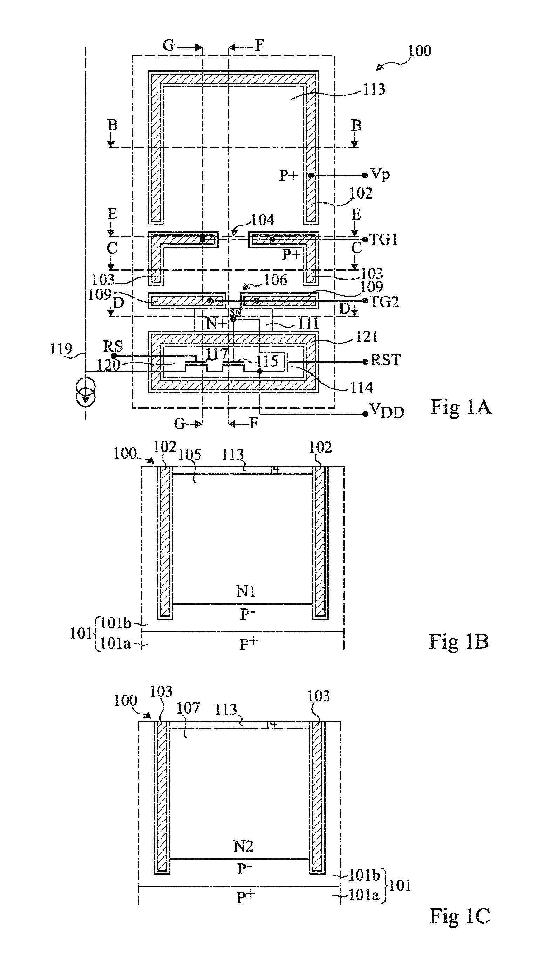

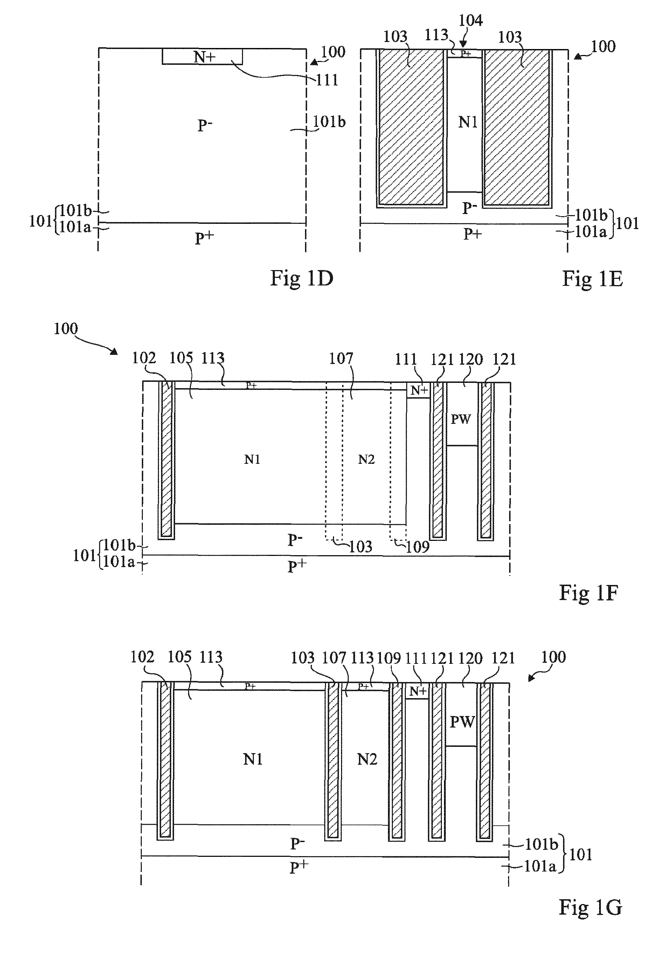

Les figures 1A à 1G représentent de façon schématique un exemple d'un pixel 100 d'un capteur d'image réalisé dans et sur un substrat semiconducteur 101, par exemple en silicium. La figure 1A représente le pixel 100 en vue de dessus, et les figures 1B à 1G sont des vues en coupe de côté, respectivement selon les plans B-B, C-C, D-D, E-E, F-F et G-G de la figure 1A. En pratique, un capteur d'image peut comporter une pluralité de pixels 100 identiques disposés dans et sur un même substrat semiconducteur, par exemple selon des lignes et des colonnes.

Le pixel 100 comprend une zone photosensible, une zone intermédiaire de stockage de charges ou zone mémoire, et une zone de lecture. La zone de stockage s'étend entre la zone photosensible et la zone de lecture, c'est-à-dire qu'elle présente un bord commun avec la zone photosensible, et un autre bord commun avec la zone de lecture. Le pixel 100 comprend en outre un dispositif permettant de transférer des charges de la zone photosensible vers la zone de stockage, et de la zone de stockage vers la zone de lecture, la zone de lecture étant connectée à un circuit de lecture du pixel.

Dans cet exemple, le substrat 101 comprend un support 101a de silicium fortement dopé de type P (P+), et une couche 101b faiblement dopée de type P (P-), par exemple une couche épitaxiée, revêtant la surface supérieure du support 101a. La zone photosensible du pixel 100 comprend un caisson 105 dopé de type N, de niveau de dopage N1, formé dans une partie supérieure de la couche 101b. La zone de stockage du pixel comprend, juxtaposé au caisson 105, un caisson 107 dopé de type N, de niveau de dopage N2, formé dans une partie supérieure de la couche 101b. Dans cet exemple, les caissons 105 et 107 ont sensiblement la même profondeur. Les modes de réalisation décrits ne se limitent toutefois pas à ce cas particulier. Les caissons 105 et 107 sont par exemple approximativement parallélépipédiques avec un côté commun. Les dimensions et niveaux de dopage des caissons 105 et 107 sont de préférence choisis de façon que la zone photosensible et la zone de stockage du pixel aient des capacités de stockage de charges sensiblement égales. Dans cet exemple, le caisson 105 a, vu de dessus, une surface supérieure à celle du caisson 107, et son niveau de dopage (N1) est inférieur à celui (N2) du caisson 107, de sorte que la zone photosensible et la zone de stockage du pixel ont des capacités de stockage de charges sensiblement égales. Une mince couche 113 fortement dopée de type P (P+) peut être formée en surface des caissons 105 et 107. La zone de lecture du pixel 100 comprend, juxtaposée au caisson 107, du côté du caisson 107 opposé au caisson 105 dans cet exemple, une région 111 fortement dopée de type N (N+). La région 111 est plus fortement dopée que les caissons 105 et 107, et s'étend dans une partie supérieure de la couche 101a, sur une profondeur inférieure à celle du caisson 107.

A titre d'exemple non limitatif, la couche 101b peut avoir une épaisseur comprise entre 1 et 30 µm, les caissons 105 et 107 peuvent avoir chacun une épaisseur comprise entre 1 et 10 µm, et de préférence entre 2 et 4 µm, la région de lecture 111 peut avoir une épaisseur comprise entre 0,1 et 0,5 µm, et les niveaux de dopage peuvent être compris entre 1*10¹⁴ et 1*10¹⁶ atomes/cm³ pour la couche 101b, entre 1*10¹⁸ et 1*10²⁰ atomes/cm³ pour le support 101a, entre 1*10¹⁶ et 1*10¹⁸ atomes/cm³ pour les caissons 105 et 107, et entre 1*10¹⁹ et 1*10²² atomes/cm³ pour la région 111. A titre de variante, le support 101a peut avoir un niveau de dopage plus faible que 1*10¹⁸ atomes/cm³. A titre d'exemple, le support 101a peut être faiblement dopé de type P, par exemple de niveau de dopage inférieur à 1*10¹⁵ atomes/cm³. A titre d'exemple, le support 101a peut être non intentionnellement dopé.

Une électrode ou grille verticale isolée 103 s'étend depuis la face supérieure ou face avant du substrat, entre les caissons 105 et 107, au niveau de leur côté commun. L'électrode 103 s'étend jusqu'à une profondeur au moins égale à celle du plus profond des caissons 105 et 107. L'électrode 103 isole le caisson 105 du caisson 107, sauf en une zone 104 de transfert de charges, définie par une ouverture formée dans l'électrode 103 et reliant le caisson 105 au caisson 107. Dans l'exemple représenté, l'électrode 103 s'étend jusqu'à une profondeur légèrement supérieure à celle des caissons 105 et 107, et a, vu de dessus, la forme d'un U délimitant l'essentiel de trois côtés du caisson 107, la barre horizontale du U étant située en regard du côté commun aux caissons 105 et 107. L'ouverture définissant la zone de transfert 104 est située dans le pan de l'électrode 103 situé entre les caissons 105 et 107 (correspondant à la barre horizontale du U en vue de dessus), et a la forme d'une bande verticale s'étendant sur toute la hauteur de l'électrode 103.

Une autre électrode ou grille verticale isolée 109 s'étend depuis la face avant du substrat, entre le caisson 107 et la région de lecture 111, au niveau de leur côté commun. L'électrode 109 s'étend sur une profondeur sensiblement identique à celle de l'électrode 103. L'électrode 109 isole le caisson 107 de la région 111, sauf en une zone 106 de transfert de charges, définie par une ouverture formée dans l'électrode 109 et reliant le caisson 107 à la région 111. Dans l'exemple représenté, l'électrode 109 a la forme d'un pan vertical délimitant l'essentiel du côté du caisson 107 juxtaposé à la région 111 (c'est-à-dire le côté du caisson 107 opposé à la zone de transfert 104), s'étendant sur une profondeur légèrement supérieure à celle du caisson 107, et comporte une ouverture en forme de bande verticale, qui s'étend sur toute sa hauteur et délimite la zone de transfert 106.

Dans l'exemple représenté, une autre électrode ou grille verticale isolée 102 s'étend depuis la face avant du substrat, délimitant latéralement l'essentiel des trois côtés du caisson 105 non délimités par l'électrode 103. L'électrode 102 a par exemple sensiblement la même profondeur que les électrodes 103 et 109.

Pour former les électrodes 102, 103 et 109, on peut par exemple former, autour des caissons 105 et 107, des tranchées s'étendant verticalement dans le substrat depuis sa face avant, selon un motif correspondant à la forme souhaitée des électrodes. Les parois latérales et le fond des tranchées peuvent être revêtus d'un matériau isolant, par exemple de l'oxyde de silicium, puis les tranchées peuvent être remplies d'un matériau conducteur. A titre d'exemple, le matériau conducteur de remplissage des tranchées est du silicium polycristallin fortement dopé, par exemple de niveau de dopage compris entre 1x10¹⁸ et 1x10²⁰ atomes/cm³, ou un métal, par exemple du cuivre ou du tungstène. A titre d'exemple non limitatif, les tranchées peuvent avoir une profondeur comprise entre 1 et 10 µm, et de préférence entre 2 et 5 µm, et une largeur comprise entre 0,1 et 0,5 µm.

On notera que les formes, vu de dessus, des électrodes 102, 103 et 109, illustrées en figure 1A, sont uniquement indicatives et peuvent différer dans un souci d'amélioration du transfert des charges. La forme de l'électrode 102 peut en particulier varier si la zone de détection est une photodiode pincée (en anglais "pinned photo-diode") ou contrôlée par les capacités MOS (Metal Oxyde Semiconducteur) définies par les tranchées conductrices isolées.

Les faces supérieures ou faces avant des électrodes 102, 103 et 109 et de la région 111 sont reliées par des métallisations (non représentées), respectivement à un noeud Vp d'application d'un signal de polarisation, à des noeuds TG1 et TG2 d'application de signaux de commande en transfert de charges, et à un noeud SN relié ou couplé à un circuit de lecture de tension.

Dans l'exemple représenté, le circuit de lecture (figure 1A) comprend un transistor 114 reliant le noeud SN à un rail d'alimentation haute V_{DD} du capteur, un transistor 115 monté en source suiveuse, dont la grille est reliée au noeud SN et dont le drain est relié au rail V_{DD}, et un transistor 117 reliant la source du transistor 115 à une ligne de lecture 119 d'un réseau matriciel comportant le pixel 100. La grille du transistor 114 est reliée à un noeud RST d'application d'un signal de commande en réinitialisation de la région 111, et la grille du transistor 117 est reliée à un noeud RS d'application d'un signal de sélection du pixel 100. Dans cet exemple, les transistors 114, 115 et 117 sont formés dans un caisson 120 dopé de type P (PW), délimité latéralement par une région d'isolement 121. Dans cet exemple, la région d'isolement 121 comprend une tranchée à parois isolées remplie d'un matériau conducteur entourant le caisson 120, cette tranchée pouvant être formée en même temps que les électrodes verticales 102, 103 et 109. La région d'isolement 121 peut toutefois être remplacée par tout autre dispositif connu d'isolation périphérique d'un caisson comportant des transistors, par exemple une tranchée de type STI ou une isolation par jonction.

Un exemple d'un mode d'utilisation ou de commande du pixel 100 va maintenant être décrit.

En phase d'accumulation de charges ou d'intégration, les signaux Vp et TG1 sont fixés à un potentiel de référence. A titre d'exemple, ce potentiel peut être celui de la masse, ou être négatif par rapport à la masse, par exemple de l'ordre de -1 V. Une telle polarisation des électrodes 102 et 103 entraîne une accumulation de trous le long des parois des tranchées verticales délimitant la zone photosensible. Des trous s'accumulent également dans la zone de transfert 104, bloquant les échanges d'électrons entre les caissons 105 et 107. Le substrat 101 étant lui aussi polarisé à un potentiel de référence, par exemple celui de la masse, il se forme un puits de potentiel dans la zone photosensible, qui, en l'absence d'éclairement, dépend des niveaux de dopage et des potentiels de polarisation des électrodes et du substrat. Les niveaux de dopage et les potentiels de polarisation sont de préférence choisis de façon que, en l'absence d'éclairement et après réinitialisation, le caisson 105 de la zone photosensible soit entièrement déplété (vide de porteurs majoritaires, c'est-à-dire d'électrons dans cet exemple). Lorsque le pixel est éclairé, des paires électrons/trous sont photogénérées dans la zone photosensible, et les électrons photogénérés sont collectés par le caisson 105.

En phase de transfert des charges photogénérées accumulées dans la zone photosensible vers la zone intermédiaire de stockage, le signal Vp reste inchangé, c'est-à-dire que l'électrode 102 reste polarisée au même potentiel de référence que pendant la phase d'accumulation. Ce même potentiel de référence est également appliqué au signal TG2, ce qui entraîne l'accumulation de trous dans la zone de transfert 106, bloquant les échanges d'électrons entre le caisson 107 et la région 111. Le signal TG1 est mis à une valeur supérieure au potentiel maximal du puits de potentiel formé dans la zone photosensible pendant l'intégration, par exemple à une valeur comprise entre 2 et 3 V. Ceci entraîne le transfert des électrons photogénérés contenus dans le caisson 105 vers le caisson 107, via la zone de transfert 104. Une fois le transfert effectué, le signal TG1 est à nouveau mis à la même valeur basse que les signaux Vp et TG2, de façon à créer, dans la zone de stockage, un puits de potentiel adapté à maintenir les électrons transférés confinés dans le caisson 107, dans l'attente d'un transfert ultérieur vers la zone de lecture 111. A ce stade, la zone photosensible est vide de toute charge photogénérée, c'est-à-dire dans un état réinitialisé, et une nouvelle phase d'intégration peut commencer.

En phase de transfert des charges contenues dans la zone de stockage vers la zone de lecture 111, les signaux Vp et TG1 sont maintenus au même potentiel de référence de valeur basse que pendant la phase d'intégration. Le signal TG2 est mis à une valeur supérieure au potentiel maximal du puits de potentiel formé dans la zone de stockage pendant la phase de stockage intermédiaire, par exemple à une valeur comprise entre 2 et 3 V. Ceci entraîne le transfert des électrons photogénérés contenus dans le caisson 107 vers la région 111, via la zone de transfert 106. Une fois le transfert effectué, le signal TG2 est à nouveau mis à la même valeur basse que les signaux Vp et TG1, de façon à bloquer les échanges d'électrons entre le caisson 107 et la région 111. A ce stade, la zone de stockage est vide de toute charge photogénérée, c'est-à-dire dans un état réinitialisé. Les niveaux de dopage et les potentiels de polarisation sont de préférence choisis de façon que, à l'état réinitialisé, le caisson 107 de la zone de stockage soit entièrement déplété (vide de porteurs majoritaires, c'est-à-dire d'électrons dans cet exemple).

Comme cela a été détaillé dans les demandes de brevet US2014183685 et EP2752878 susmentionnées, les structures du type décrit en relation avec les figures 1A à 1G sont particulièrement bien adaptées à un mode de commande à obturation globale, notamment du fait de la présence, dans chaque pixel, d'une zone de stockage ou point mémoire, qui permet de stocker de façon relativement immune au bruit les charges photogénérées accumulées dans la photodiode pendant l'intégration, en attendant d'effectuer la lecture de ces charges via la zone de lecture et le circuit de lecture. A titre d'exemple, pendant une période d'intégration commune à tous les pixels du capteur, des charges photogénérées sont accumulées dans les zones photosensibles des pixels du capteur. A la fin de l'intégration, une phase de transfert est mise en oeuvre simultanément dans tous les pixels du capteur, dans laquelle, dans chaque pixel, les charges photogénérées accumulées dans la zone photosensible sont transférées dans la zone de stockage. Après la phase de transfert, une image complète est mémorisée dans les différentes zones de stockage du capteur. L'image mémorisée peut ensuite être lue, ligne par ligne, via la zone de lecture et le circuit de lecture, pendant la période d'intégration suivante du capteur.

Bien que cela n'ait pas été représenté sur les figures 1A à 1G, le pixel 100 comprend en outre un écran opaque, par exemple métallique, situé du côté de sa face supérieure ou face avant, masquant toute la surface de la zone de stockage du pixel. A titre d'exemple, l'écran opaque masque toute la surface du pixel à l'exception de sa zone photosensible. Un tel écran permet notamment d'éviter que des charges ne soient photogénérées et accumulées dans la zone de stockage pendant la période de mémorisation d'un niveau d'éclairement par la zone de stockage, ce qui viendrait altérer l'information stockée.

En pratique, on constate toutefois que les structures connues de pixels à électrodes verticales ne permettent pas de s'affranchir totalement d'un bruit lié à une accumulation de charges parasites dans la zone de stockage, notamment pendant la période de mémorisation d'un signal par la zone de stockage. Ceci pose tout particulièrement problème dans le cas d'une commande à obturation globale du type décrit ci-dessus. En effet, dans ce cas, la durée de stockage du signal par la zone de stockage peut être particulièrement longue pour certains pixels du capteur (typiquement du même ordre de grandeur que la période d'intégration pour les derniers pixels dans l'ordre de lecture des pixels du capteur). De plus, la durée de stockage du signal par la zone de stockage n'est pas la même pour tous les pixels du capteur. La diffusion de charges parasites vers la zone de stockage peut ainsi provoquer des artefacts particulièrement gênants dans l'image finale.

Il serait souhaitable de pouvoir disposer d'une structure de pixel à électrodes verticales compatible avec une commande à obturation globale, dans laquelle la zone intermédiaire de stockage du pixel est mieux isolée des diffusions de charges parasites que dans les structures connues.

Les inventeurs ont notamment identifié qu'une source de charges parasites dans les structures du type décrit en relation avec les figures 1A à 1G provient des rayons lumineux de longueurs d'ondes élevées, qui sont susceptibles d'être absorbés à une profondeur supérieure à celle de l'électrode 103 du pixel, par exemple dans le support de silicium 101a. Les charges photogénérées à une profondeur supérieure à celle de l'électrode 103 peuvent être recombinées dans le support 101a, ou collectées par le caisson 105 de la zone photosensible. Toutefois, les inventeurs ont constaté qu'une partie de ces charges diffuse latéralement sous l'électrode 103, et est collectée par le caisson 107 de la zone de stockage, altérant ainsi l'information mémorisée dans la zone de stockage.

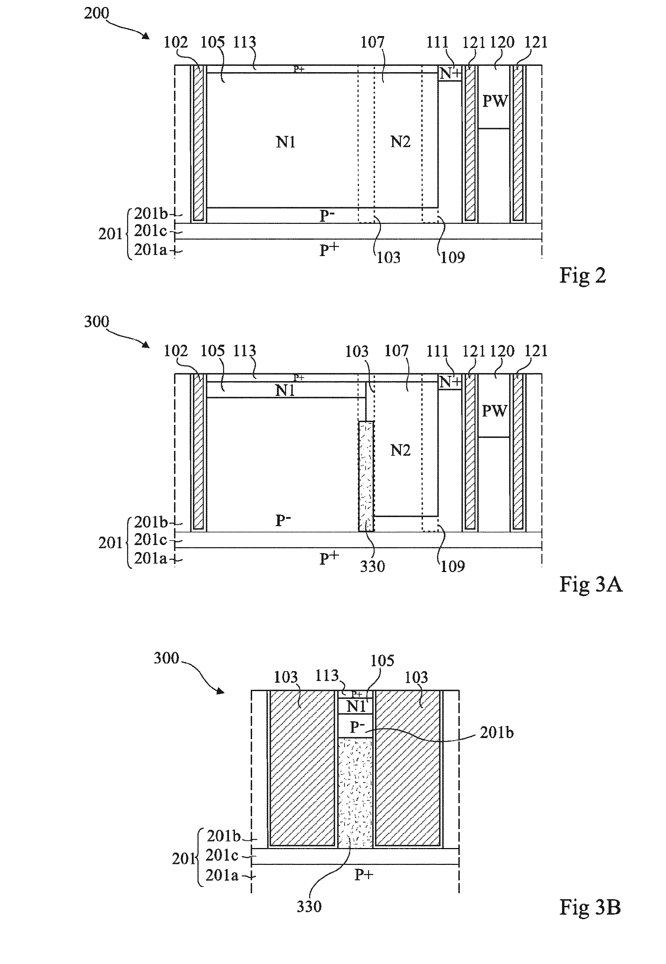

La figure 2 représente de façon schématique la structure d'un exemple d'un pixel 200 d'un capteur d'image selon un premier mode de réalisation. Le pixel 200 comprend des éléments communs avec le pixel 100 des figures 1A à 1G. Ces éléments ne seront pas décrits à nouveau. Dans la suite, seules les différences entre les pixels 100 et 200 seront détaillées. La figure 2 est une vue en coupe du pixel 200 selon un plan de coupe identique à celui de la figure 1F.

Selon un aspect du mode de réalisation de la figure 2, le pixel 200 comprend une couche isolante s'étendant horizontalement sous toute la surface de la zone photosensible et de la zone de stockage du pixel, par exemple sous toute la surface du pixel, la face supérieure ou face avant de cette couche étant en contact avec la face inférieure ou face arrière de l'électrode 103 de commande de transfert de charges entre la zone photosensible et la zone de stockage du pixel.

Le pixel 200 de la figure 2 est formé dans et sur un substrat 201 de type semiconducteur sur isolant (SOI). Dans cet exemple, le substrat 201 comprend un support 201a de silicium fortement dopé de type P (P+), par exemple identique ou similaire au support 101a du pixel 100 des figures 1A à 1G, une couche 201b faiblement dopée de type P (P-), par exemple identique ou similaire à la couche 101b du pixel 100 des figures 1A à 1G, et une couche isolante 201c, par exemple en oxyde de silicium, disposée entre le support 201a et la couche 201b. Le pixel 200 comprend, formés dans et sur la couche 201b, sensiblement les mêmes éléments que les éléments du pixel 100 formés dans et sur la couche 101b du pixel 100.

La face supérieure ou face avant de la couche isolante 201c est en contact avec la face inférieure ou face arrière de l'électrode verticale isolée 103 séparant le caisson 105 du caisson 107. En d'autres termes, l'électrode isolée 103 s'étend verticalement sur toute l'épaisseur de la couche 201b. Dans l'exemple représenté, les électrodes isolées 102 et 109 et la région d'isolement 121 ont la même profondeur que l'électrode 103, et ont donc leurs faces inférieures ou faces arrière en contact avec la face avant de la couche isolante 201c. Les caissons 105 et 107 peuvent s'étendre sur toute l'épaisseur de la couche 201b, ou sur une épaisseur inférieure à celle de la couche 201b comme cela est représenté sur la figure 2.

Un avantage du pixel 200 de la figure 2 par rapport au pixel 100 des figures 1A à 1G est qu'il empêche que des charges photogénérées à une profondeur supérieure à celle de l'électrode 103 ne soient collectées par le caisson 107 de la zone de stockage. En effet, lorsqu'un rayon de longueur d'onde élevée atteint la zone photosensible du pixel 200, les photons correspondants peuvent traverser le caisson 105 puis la couche isolante 201c, et être absorbés dans le support de silicium 201a, entraînant la génération de paires électron-trou. Toutefois, les électrons photogénérés correspondants ne peuvent pas traverser la couche diélectrique 201c. Ils ne peuvent donc être collectés ni par le caisson 105 de la zone photosensible, ni par le caisson 107 de la zone de stockage, et finissent par se recombiner avec des trous du support 201a.

Les figures 3A et 3B représentent de façon schématique la structure d'un exemple d'un pixel 300 d'un capteur d'image selon un deuxième mode de réalisation. Le pixel 300 comprend des éléments communs avec le pixel 200 de la figure 2. Ces éléments ne seront pas décrits à nouveau. Dans la suite, seules les différences entre les pixels 200 et 300 seront détaillées. Les figures 3A et 3B sont des vues en coupe du pixel 300 selon des plans de coupe identiques à ceux des figures 1F et 1E respectivement.

Le pixel 300 des figures 3A et 3B diffère du pixel 200 de la figure 2 en ce que, dans le pixel 300, le caisson 105 de la zone photosensible présente une profondeur nettement plus faible que dans le pixel 200, par exemple une profondeur comprise entre 0,3 et 0,8 µm. En particulier, dans le pixel 300, la profondeur du caisson 105 est, à titre d'exemple, inférieure à celle du caisson 107 de la zone de stockage, et inférieure à celle de l'électrode de transfert 103. Dans le pixel 300, l'épaisseur du caisson 105 et les niveaux de dopage du caisson 105, de la couche 113 et de la couche 201b, sont choisis de façon que les régions 105 et 201b forment une diode pincée, ou diode totalement déplétée, c'est-à-dire de façon que, après réinitialisation, en l'absence de polarisation des électrodes 102 et 103 et du substrat, et en l'absence d'éclairement, le caisson 105 soit entièrement vide de porteurs majoritaires. Dans ces conditions, il se forme un puits de potentiel dans la zone photosensible, qui dépend uniquement des niveaux de dopage choisis. Le fonctionnement du pixel 300 peut être identique ou similaire à ce qui a été décrit en relation avec les figures 1A à 1G.

Dans une telle structure, la profondeur du puits de potentiel formé au niveau de la zone photosensible pendant l'intégration peut être supérieure à la profondeur du caisson 105, mais reste nettement inférieure à la profondeur de l'électrode 103. Ainsi, lorsque des photons sont absorbés au niveau de la zone photosensible à une profondeur intermédiaire comprise entre la face inférieure du caisson 105 et la face inférieure de l'électrode 103, les charges photogénérées résultantes sont susceptibles de diffuser vers la zone de stockage, via la partie inférieure de l'ouverture formée dans l'électrode 103 (qui n'est pas bloquante du fait que la partie inférieure de la couche 201b n'est pas déplétée). Ces charges peuvent alors être collectées par le caisson 107 de la zone de stockage, altérant ainsi l'information mémorisée par la zone de stockage.

Pour remédier à ce problème, selon un aspect du mode de réalisation des figures 3A et 3B, le pixel 300 comprend un mur d'isolement 330 s'étendant verticalement dans ou en regard d'une partie inférieure de l'ouverture formée dans l'électrode 103 et définissant la zone de transfert de charges 104, ou sous cette ouverture, de façon que la profondeur de la zone de transfert de charges 104 soit inférieure à la profondeur de l'électrode 103.

De préférence, la face inférieure ou face arrière du mur d'isolement 330 est située à une profondeur identique ou supérieure à celle de la face inférieure de l'électrode 103, et la face supérieure ou face avant du mur d'isolement 330 est située à une profondeur supérieure à celle de la face inférieure ou face arrière du caisson 105. Dans l'exemple représenté, le mur d'isolement 330 s'étend verticalement dans une partie inférieure de l'ouverture formée dans l'électrode 103 et délimitant la zone de transfert 104, de façon à isoler la zone photosensible de la zone de stockage au niveau de la partie inférieure de cette ouverture.

Dans l'exemple des figures 3A et 3B, le mur d'isolement 330 est constitué par une région fortement dopée de type P, par exemple de niveau de dopage compris entre 1*10¹⁷ et 1*10¹⁹ atomes/cm³. Le dopage de la région 330 est par exemple réalisé par implantation en profondeur depuis la face avant du substrat, par exemple avant la formation des caissons 105 et 107 et de la couche 113.

Lorsque des photons sont absorbés au niveau de la zone photosensible à une profondeur supérieure à la profondeur maximale du puits de potentiel de la zone photosensible, et inférieure à la profondeur de l'électrode 103, le mur d'isolement 330 permet d'éviter que les charges photogénérées correspondantes puissent atteindre la zone de stockage. Ces charges sont alors recombinées dans la couche 201b ou le mur 330, ou collectées par la région d'accumulation de la zone photosensible.

Comme cela est représenté sur les figures 3A et 3B, le mode de réalisation décrit en relation avec les figures 3A et 3B, à savoir la prévision d'un mur d'isolement vertical limitant la zone de transfert de charges 104 à une profondeur inférieure à celle de l'électrode 103, peut être combiné avec le mode de réalisation de la figure 2, à savoir la prévision d'une couche isolante en contact avec la face inférieure de l'électrode 103 sous la surface du pixel. Ceci présente l'avantage de limiter considérablement les risques de collecte de charges parasites par la zone de stockage pendant la durée de mémorisation d'un niveau de signal par la zone de stockage, et ce quelles que soient les longueurs d'ondes d'éclairement du capteur.

Toutefois, le mode de réalisation des figures 3A et 3B (mur d'isolement vertical) peut aussi être utilisé indépendamment du mode de réalisation de la figure 2 (couche isolante sous la surface du pixel). En particulier, dans le pixel 300 des figures 3A et 3B, si la gamme des longueurs d'ondes d'éclairement du pixel ne comprend pas de longueurs d'ondes susceptibles d'être absorbées à une profondeur supérieure à celle de l'électrode 103, la couche isolante 201c peut être omise.

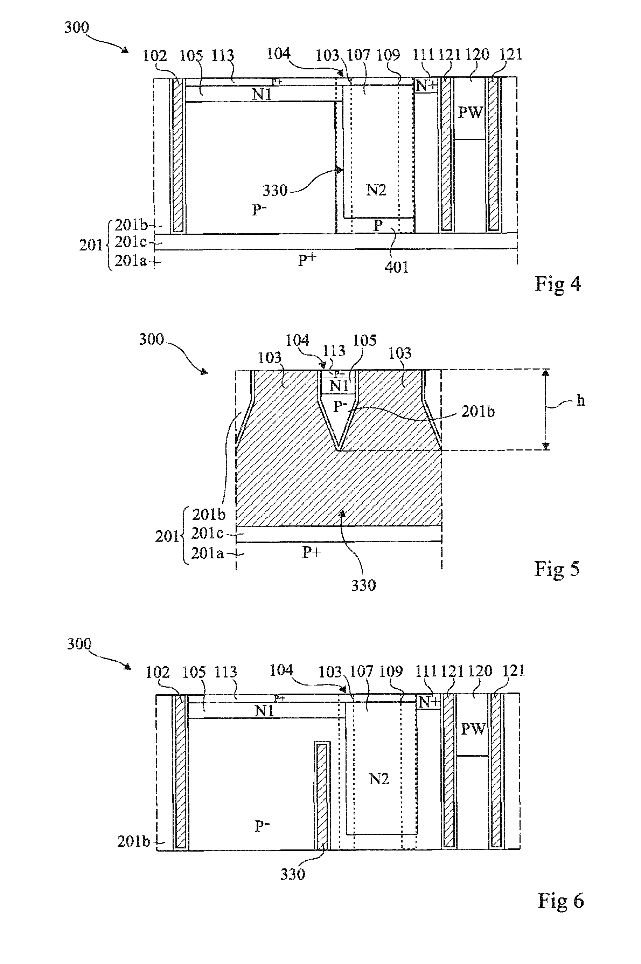

La figure 4 représente de façon schématique une variante de réalisation du pixel 300 des figures 3A et 3B. La figure 4 est une vue en coupe du pixel 300 selon un plan de coupe identique à celui de la figure 3A. Seules les différences entre le pixel 300 de la figure 4 et le pixel 300 des figures 3A et 3B seront détaillées ci-après.

Le pixel 300 de la figure 4 diffère du pixel 300 des figures 3A et 3B essentiellement par la manière de réaliser son mur d'isolement vertical 330. Dans cet exemple, avant la formation des caissons de type N 105 et 107, un caisson 401 de type P, de niveau de dopage supérieur à celui de la couche 201b, est formé dans la couche 201b depuis la face avant du substrat, ce caisson s'étendant, vu de dessus sur toute la surface de la zone de stockage et de la zone de transfert de charges 104, et s'interrompant au niveau de la zone photosensible du pixel. Le niveau de dopage du caisson 401 est par exemple compris entre 1*10¹⁶ et 1*10¹⁹ atomes/cm³. La profondeur du caisson 401 est de préférence supérieure à la profondeur du caisson 107.

Après la formation du caisson 401, les caissons 105 et 107 de type N sont formés. En vue de dessus (non représentée), les caissons 105 et 107 ont un bord adjacent situé à l'intérieur du caisson 401. Plus particulièrement, dans l'exemple représenté, la partie du caisson 401 située sous le caisson 105 (dans l'ouverture verticale formée dans l'électrode 103), forme le mur d'isolement vertical 330 permettant d'empêcher la diffusion latérale de charges parasites de la zone photosensible vers la zone de stockage, par l'intermédiaire de l'ouverture formée dans l'électrode 103.

Dans l'exemple représenté, le caisson 401 a une profondeur supérieure à celle du caisson 107 de la zone de stockage, ce qui présente l'avantage supplémentaire de bloquer la diffusion de charges parasites vers la zone de stockage par la face inférieure de la zone de stockage. A titre de variante, le caisson 401 peut avoir la même profondeur que le caisson 107.

La figure 5 représente de façon schématique une autre variante de réalisation du pixel 300 des figures 3A et 3B. La figure 5 est une vue en coupe du pixel 300 selon un plan de coupe identique à celui de la figure 3B. Seules les différences entre le pixel 300 de la figure 5 et le pixel 300 des figures 3A et 3B seront détaillées ci-après.

Le pixel 300 de la figure 5 diffère du pixel 300 des figures 3A et 3B essentiellement par la nature de son mur d'isolement vertical 330. Dans l'exemple de la figure 5, l'ouverture formée dans l'électrode verticale isolée 103, définissant la région de transfert de charges 104 du pixel, a une profondeur inférieure à la profondeur de l'électrode 103. Ainsi, le mur d'isolement vertical 330 est constitué par la portion d'électrode isolée 103 située sous l'ouverture formée dans l'électrode 103, c'est-à-dire sous la région de transfert de charges 104.

Pour réaliser une électrode 103 présentant une ouverture verticale s'étendant sur une profondeur inférieure à la profondeur totale de l'électrode, on peut prévoir de former des tranchées selon un motif ayant, vu de dessus, sensiblement la même forme que ce qui a été décrit précédemment, mais en utilisant un procédé de gravure adapté à réaliser des tranchées dont la partie inférieure est plus large que la partie supérieure, ou tranchées évasées, parfois appelées tranchées en forme de bouteille. L'espacement entre les portions d'électrode 103 au niveau de la surface supérieure du substrat est choisi de façon que les tranchées se rejoignent à une profondeur h déterminée, inférieure à la profondeur maximale de l'électrode 103, et de préférence supérieure à la profondeur du caisson 105. La distance h correspond à la hauteur de la zone de transfert de charges. Les parois latérales et le fond des tranchées peuvent ensuite être revêtus d'un matériau isolant, puis les tranchées peuvent être remplies d'un matériau conducteur.

La figure 6 représente de façon schématique une autre variante de réalisation du pixel 300 des figures 3A et 3B. La figure 6 est une vue en coupe du pixel 300 selon un plan de coupe identique à celui de la figure 3A. Seules les différences entre le pixel 300 de la figure 6 et le pixel 300 des figures 3A et 3B seront détaillées ci-après.

Le pixel 300 de la figure 6 diffère du pixel 300 des exemples précédents en ce qu'il est destiné à être éclairé par sa face arrière, alors que les exemples des figures 3A et 3B, 4 et 5 visaient des pixels à éclairement par la face avant. Le pixel 300 de la figure 6 diffère en outre du pixel 300 des figures 3A et 3B par la nature de son mur d'isolement vertical 330.

La réalisation du pixel 300 de la figure 6 comprend sensiblement les mêmes étapes que la réalisation du pixel 300 des figures 3A à 3B, à l'exception de l'étape de formation du mur d'isolement 330, et comprend en outre, après la formation des divers éléments du pixel côté face avant du substrat (notamment les électrodes 102, 103 et 109, les caissons 105, 107 et 120, les régions 111 et 121, et la couche 113), une étape d'amincissement du substrat 201 par sa face arrière. Dans l'exemple représenté, lors de l'amincissement, seule la couche 201b du substrat 201 est conservée, c'est-à-dire que l'amincissement est arrêté après le retrait du support 201a et de la couche isolante 201c. Un revêtement de protection peut être disposé sur la face arrière du pixel après l'amincissement. A titre de variante, la couche 201c peut être conservée en totalité ou en partie, de façon à protéger la face arrière du pixel. Préalablement à l'amincissement, une poignée de support (non représentée) peut être accolée au capteur du côté de sa face avant. A titre de variante, le pixel 300 de la figure 6 peut être réalisé à partir d'un substrat semiconducteur du type décrit en relation avec les figures 1A à 1G, ne comportant pas de couche isolante intermédiaire.

Dans l'exemple de la figure 6, le mur 330 est constitué par une tranchée verticale isolante formée après l'étape d'amincissement, à partir de la face arrière du substrat, dans ou en regard d'une partie inférieure de l'ouverture verticale formée dans l'électrode 103 et définissant la zone de transfert de charges 104. La tranchée isolée formant le mur 330 s'arrête de préférence à un niveau inférieur à la face inférieure du caisson 105. Dans l'exemple représenté, la tranchée isolante formant le mur 330 est située en regard de la partie inférieure de l'ouverture formée dans l'électrode 103, c'est-à-dire décalée latéralement par rapport à l'électrode 103. Ceci permet de simplifier la réalisation de cette tranchée, en réduisant les contraintes d'alignement par rapport à l'électrode 103. Toutefois, pour obtenir un effet significatif d'isolement de la zone de stockage, la distance latérale entre la tranchée formant le mur 330 et l'électrode 103 sera de préférence choisie relativement faible, par exemple comprise entre 50 et 400 nm. Dans l'exemple représenté, la tranchée formant le mur 330 est située côté zone photosensible. A titre de variante, la tranchée formant le mur 330 est située côté zone de stockage.

Dans l'exemple représenté, la tranchée formant le mur 330 est du même type que les électrodes verticales isolées du capteur, c'est-à-dire que les parois de la tranchée sont revêtues d'une couche isolante, le coeur de la tranchée étant rempli d'un matériau conducteur. A titre de variante, la tranchée peut être entièrement remplie d'un matériau isolant, par exemple de l'oxyde de silicium.

Des modes de réalisation particuliers ont été décrits. Diverses variantes et modifications apparaîtront à l'homme de l'art.

En particulier, les modes de réalisations décrits peuvent être adaptés à d'autres structures de pixels à électrodes verticales comportant une zone photosensible et une zone de stockage que celles décrites ci-dessus. Par exemple, l'homme de l'art saura adapter les modes de réalisation décrits à une structure de pixel comportant en outre un dispositif anti-éblouissement accolé à la zone photosensible, permettant d'éviter que, en cas de saturation de la zone photosensible pendant une période d'intégration, un surplus de charges photogénérées ne se déverse dans la zone intermédiaire de stockage, entraînant une pollution de l'image acquise pendant la période d'intégration précédente. Plus particulièrement, les modes de réalisation décrits peuvent être adaptés à une structure de pixel du type décrit en relation avec les figures 4 et 5 des demandes de brevet US2014183685 et EP2752878 susmentionnées.

De plus, les modes de réalisation décrits peuvent être adaptés à des structures de pixels dans lesquelles tous les types de conductivité sont inversés par rapport aux exemples susmentionnés.

En outre, les modes de réalisation décrits ne se limitent pas à l'exemple de circuit de lecture représenté en figure 1A. L'homme de l'art saura obtenir le fonctionnement recherché en utilisant d'autres circuits de lecture connus.

## Revendications

1. Capteur d'image disposé dans et sur un substrat semiconducteur (201) ayant une face avant et une face arrière, ce capteur comportant une pluralité de pixels (200 ; 300) comprenant chacun :
une zone photosensible (105), une zone de lecture (111), et une zone de stockage (107) s'étendant entre la zone photosensible (105) et la zone de lecture (111) ;
une première électrode verticale isolée (103) s'étendant depuis la face avant du substrat entre la zone photosensible (105) et la zone de stockage (107), comprenant au moins une ouverture s'étendant depuis la face avant du substrat et définissant une zone de transfert de charges (104) entre la zone photosensible (105) et la zone de stockage (107) ; et
au moins un élément d'isolement parmi les suivants :
a) une couche (201c) en un matériau isolant s'étendant au moins sous toute la surface de la zone photosensible (105) et sous toute la surface de la zone de stockage (107) et ayant sa face avant en contact avec la face arrière de ladite électrode (103) ; et
b) un mur d'isolement (330) s'étendant verticalement dans ou en regard d'une partie inférieure de ladite ouverture, ou sous ladite ouverture, de façon que la profondeur de la zone de transfert de charges (104) soit inférieure à la profondeur de ladite électrode (103).

2. Capteur selon la revendication 1, dans lequel chaque pixel (200 ; 300) comprend au moins l'élément d'isolement a).

3. Capteur selon la revendication 2, dans lequel le substrat (201) est un substrat de type SOI comportant un support semiconducteur (201a) revêtu d'une couche isolante (201c) revêtue d'une couche semiconductrice (201b), et dans lequel, dans chaque pixel (200 ; 300), l'élément d'isolement a) est la couche isolante (201c) du substrat.

4. Capteur selon la revendication 3, dans lequel, dans chaque pixel (200 ; 300), la zone photosensible (105), la zone de stockage (107), la zone de lecture (111), et la première électrode (103) sont disposées dans la couche semiconductrice (201b) du substrat.

5. Capteur selon l'une quelconque des revendications 1 à 4, dans lequel chaque pixel (300) comprend au moins l'élément d'isolement b).

6. Capteur selon la revendication 5, dans lequel, dans chaque pixel (300), le mur d'isolement vertical (330) comprend une région dopée de même type de conductivité que le substrat et de niveau de dopage supérieur à celui du substrat, située dans une partie inférieure de l'ouverture formée dans la première électrode (103).

7. Capteur selon la revendication 5, dans lequel, dans chaque pixel (300) l'ouverture formée dans la première électrode (103) s'étend sur une profondeur inférieure à la profondeur totale de la première électrode (103), et dans lequel le mur d'isolement (330) est constitué par la portion de la première électrode (103) située sous ladite ouverture.

8. Capteur selon la revendication 5, dans lequel, dans chaque pixel (300), le mur d'isolement (330) est constitué par une tranchée isolante verticale s'étendant depuis la face arrière du substrat, en regard d'une partie inférieure de l'ouverture formée dans la première électrode (103).

9. Capteur selon l'une quelconque des revendications 5 à 8, dans lequel, dans chaque pixel (300) :
la zone photosensible comprend un premier caisson (105) de type de conductivité opposé à celui du substrat, et la zone de stockage comprend un deuxième caisson (107) de type de conductivité opposé à celui du substrat et de profondeur supérieure à celle du premier caisson (105) ;
la première électrode (103) s'étend jusqu'à une profondeur supérieure ou égale à celle du deuxième caisson (107) ; et
le mur d'isolement vertical (330) s'étend entre le plan de face arrière de la première électrode (103), et un plan situé sous le plan de face arrière du premier caisson (105).

10. Capteur selon l'une quelconque des revendications 1 à 9, dans lequel chaque pixel (300) comprend l'élément d'isolement a) et l'élément d'isolement b).

11. Capteur selon l'une quelconque des revendications 1 à 10, dans lequel chaque pixel (200 ; 300) comporte en outre une deuxième électrode verticale isolée (109) s'étendant depuis la face avant du substrat entre la zone de stockage (107) et la zone de lecture (111), comprenant au moins une ouverture s'étendant depuis la face avant du substrat et définissant une zone de transfert de charges (106) entre la zone de stockage (107) et la zone de lecture (111).

12. Capteur selon l'une quelconque des revendications 1 à 11, dans lequel, dans chaque pixel (200 ; 300), la zone photosensible (105) est partiellement délimitée par au moins une troisième électrode verticale isolée (102) s'étendant depuis la face avant du substrat.

13. Capteur selon l'une quelconque des revendications 1 à 12, dans lequel, dans chaque pixel (200 ; 300), la zone de lecture (111) est couplée à un circuit de lecture du pixel.
